# FASCICULE DE BREVET EUROPEEN

(11) **EP 3 032 736 B1**
(45) Date de publication et mention de la délivrance du brevet: **13.09.2017**
(21) Numéro de dépôt: 16150504.5
(22) Date de dépôt: 21.11.2011
(51) Int. Cl.: H02S 40/44

(54) **PROCÉDÉ DE FABRICATION D'UN PANNEAU SOLAIRE HYBRIDE**
HERSTELLUNGSVERFAHREN EINES HYBRID-SOLARPANEELS
METHOD FOR MANUFACTURING A HYBRID SOLAR PANEL

(30) Priorité: 22.11.2010 FR 1059597
(43) Date de publication de la demande: 15.06.2016
(62) Demande divisionnaire de: 11802491.8
(73) Titulaire: Solaire 2G, 13790 Rousset (FR)
(72) Inventeur: BROTTIER, Laetitia, 13013 Marseille (FR); MOUTERDE, Jérôme, 13013 Marseille (FR)
(74) Mandataire: Roman, Alexis

(56) Documents cités:
- EP-A2- 0 981 167
- FR-A1- 2 911 997
- US-A1- 2008 302 405

## Description

### Domaine technique de l'invention.

L'invention a pour objet un procédé de fabrication d'un panneau solaire hybride.

Elle concerne le domaine technique des échangeurs thermique pour le contrôle thermique de panneaux solaires hybrides (capables de produire une énergie électrique et une énergie thermique), lesdits échangeurs comprenant des moyens pour perturber l'écoulement du fluide de refroidissement.

### État de la technique.

Les panneaux solaires photovoltaïques permettent de produire une énergie électrique à partir du rayonnement solaire. Ils comprennent une pluralité d'éléments photovoltaïques (typiquement des cellules ou des couches minces) qui fonctionnent selon le principe de l'effet photoélectrique. Généralement, plusieurs éléments photovoltaïques sont reliées entre-deux sur un panneau solaire photovoltaïque, et plusieurs panneaux sont regroupés pour former une installation solaire. Cette installation produit de l'électricité qui peut être consommée sur place ou alimenter un réseau de distribution.

Les panneaux solaires photovoltaïques ne convertissent qu'une faible part du rayonnement solaire en électricité (aujourd'hui inférieure à 20%), le reste étant de la chaleur non utilisée. Cette chaleur est défavorable à la performance électrique des panneaux solaires puisqu'on peut constater une diminution de l'efficacité des éléments photovoltaïques avec la température d'environ -0,45%/°C. C'est pourquoi il est doublement intéressant de refroidir les panneaux solaires photovoltaïques. En effet, non seulement l'efficacité des éléments photovoltaïques croît, mais les calories du refroidissement peuvent être utilisées dans des systèmes de chauffage plus ou moins complexe. On parle alors de panneaux solaires hybrides capables de produire une énergie électrique et une énergie thermique.

Généralement un échangeur thermique est disposé en vis-à-vis de la face arrière des éléments photovoltaïques de façon à refroidir ces derniers. Les documents brevets suivants décrivent un certain nombre d'échangeurs thermiques pour panneaux solaires : FR 2.319.585 (LIEBARD) ; FR 2.566.183 (LUCCIONI) ; FR 2.727.790 (CYTHELIA) ; US 4.361.717 (GILMORE) ; US 4.184.543 (KLEINE) ; US 7.076.965 (LASICH) ; DE 197.47.325 (SCHRENK) ou DE 10.2004.002.900 (MASCHKE).

Tous ces échangeurs permettent de refroidir les éléments photovoltaïques afin d'accroitre leur rendement. Toutefois, ils présentent un certains nombre d'inconvénients : leur conception peut être relativement complexe et alourdissent les panneaux, ils ne permettent pas de refroidir de manière uniforme les éléments photovoltaïques, les calories ne sont pas extraites de manière optimisée, il est nécessaire d'utiliser beaucoup d'énergie pour déplacer le fluide réfrigérant, etc.

On connait plus particulièrement par le document brevet FR 2.911.997 (DIEMUNSCH), un panneau solaire hybride dans lequel l'échangeur thermique comporte une plaque de fond disposée sous les éléments photovoltaïques et sur laquelle s'écoule un fluide de refroidissement, avec un régime d'écoulement laminaire. Des éléments permettant de perturber l'écoulement du fluide de refroidissement sont disposés sur la plaque de fond de manière à favoriser les échanges thermiques. Les éléments de perturbation peuvent être des nervures orientées dans le sens de l'écoulement, des obstacles cylindriques ou sphériques permettant la création de tourbillons tridimensionnels de type Von Karman, des ailettes dont la hauteur est inférieure à l'épaisseur de l'écoulement pour créer des tourbillons de bords de pales, ou encore des roues à aubes introduites dans la lame de fluide de manière perpendiculaire à l'écoulement.

Ces différents éléments de perturbation sont tous rapportés sur la plaque de fond. Il donc nécessaire de les fixer par collage, soudage ou vissage, étapes qui complexifient la conception et qui sont couteuses en temps. Les coûts pour fabriquer un tel échangeur thermique de façon industrielle, c'est-à-dire en grande quantité, sont donc relativement élevés.

Face à cet état des choses, le principal objectif de l'invention est de simplifier la conception des échangeurs pour panneaux solaires hybrides, de façon à ce qu'ils puissent être fabriqués de façon industrielle, plus rapidement et à moindre coûts.

Parmi les autres objectifs à atteindre par l'invention on peut citer : une uniformité de la température au niveau des éléments photovoltaïques, une extraction optimisée des calories, une robustesse du panneau solaire tout en limitant son poids.

### Divulgation de l'invention.

La solution proposée par l'invention est un procédé de fabrication d'un panneau solaire hybride conforme à la revendication 1 ou à la revendication 3.

Quelle que soit la solution retenue, le résultat technique est identique. En effet, le contact thermique entre les éléments de perturbation et la face arrière des éléments photovoltaïques (ou la plaque d'échange supérieure), assure une transmission efficace de la chaleur vers la plaque inférieure ce qui n'est pas possible avec le panneau décrit dans le document brevet FR 2.911.997 précité. La plaque inférieure peut donc extraire efficacement des calories issues des éléments photovoltaïques qui sont ensuite évacuées par le fluide de refroidissement. Ce dernier récupère donc les calories non seulement au niveau de la face arrière des éléments photovoltaïques, mais également au niveau de la plaque inférieure.

### Description des figures.

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :
- la figure 1 est une vue schématique en coupe d'un panneau solaire hybride conforme à l'invention,
- la figure 2 est une vue agrandie du détail D1 de la figure 1,
- la figure 3 est une vue schématique en coupe d'un panneau solaire hybride conforme à l'invention, dans une variante de réalisation,
- la figure 4 est une vue agrandie du détail D2 de la figure 3,
- la figure 5 est une vue en coupe selon A-A du panneau de la figure 1, les éléments de perturbations étant arrangés de manière linéaire,
- la figure 6 représente le panneau de la figure 5 dans une variante de réalisation, les éléments de perturbations étant arrangés en quinconce,
- la figure 7 est représente, en perspective, une plaque inférieure d'échange conforme à l'invention,
- la figure 8 est une vue de dessus d'un panneau solaire équipé d'un boitier de jonction EDGE,
- la figure 9 est une vue de dessous du panneau solaire de la figure 6,
- les figures 10a à 10c schématise différentes étapes de fabrication d'un échangeur monobloc.

### Modes de réalisation de l'invention.

Le panneau solaire objet de l'invention est un panneau hybride, c'est-à-dire qu'il est capable de produire une énergie électrique et une énergie thermique. Il est destiné à être utilisé seul ou en combinaison avec d'autre panneaux similaires, de façon à ce que l'énergie électrique et thermique qu'elle produit soient exploitables par une habitation ou une installation.

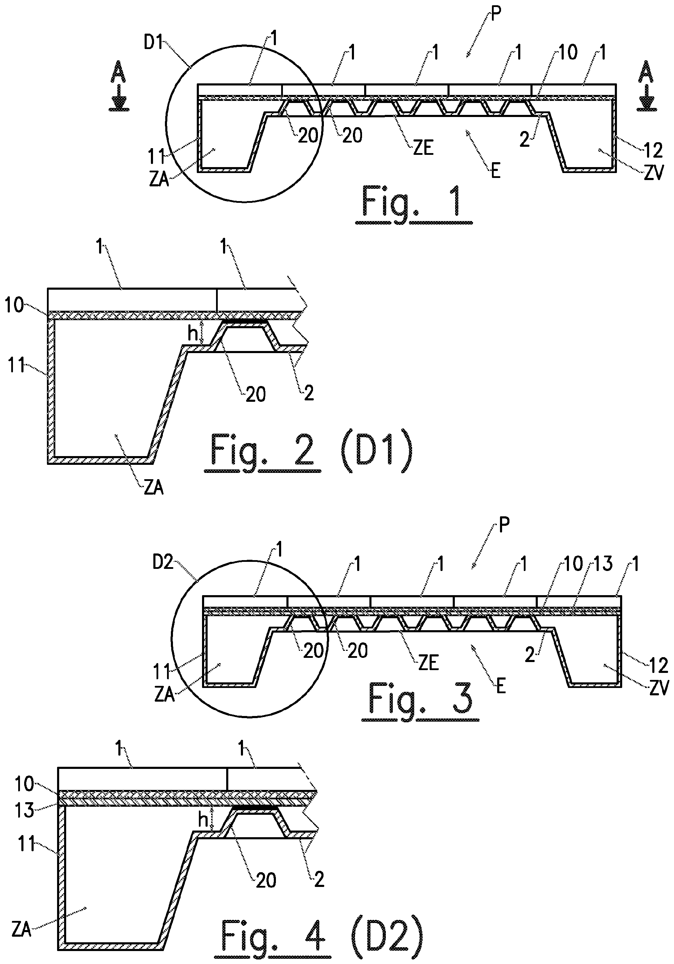

En se rapportant aux figures 1 à 4, le panneau solaire P intègre des éléments photovoltaïques 1 comportant une face avant et une face arrière. La face avant est laissée libre de façon à ce qu'elle puisse recevoir le rayonnement solaire. La face arrière est en vis-à-vis d'un échangeur thermique E. Le panneau solaire P comporte plusieurs éléments photovoltaïques 1 connectés en série ou en parallèle. Ces derniers peuvent contenir des cellules photovoltaïques, des couches minces photovoltaïques, etc. Les types d'éléments photovoltaïques susceptibles d'être employés étant bien connus de l'homme du métier, ils ne seront pas détaillés ici avec plus de précision.

En pratique, les éléments photovoltaïques 1 reposent sur l'échangeur E qui fait office de support. Ils peuvent être fixés directement sur ce dernier, ou être d'abords fixé à un cadre rigide qui peut être lui-même fixé audit échangeur. En cas de présence d'un cadre, il n'est toutefois pas nécessaire qu'il y ait fixation de l'échangeur à ce cadre, en effet, il suffit que ce dernier soit disposé sous les éléments photovoltaïques, sans assurer de fonction support. Dans tous les cas, l'échangeur E est situé sous les éléments photovoltaïques 1 de manière à ne pas faire obstacle au rayonnement solaire.

Un fluide de refroidissement, qui est typiquement de l'eau glycolée, circule dans l'échangeur E afin de récupérer les calories issues des éléments photovoltaïques 1. Pour protéger électriquement les éléments photovoltaïques 1 du fluide de refroidissement, un isolant électrique étanche 10 fait l'interface avec la face arrière desdits éléments. Il n'y a donc pas de contact direct entre les composants électriques des éléments photovoltaïques 1 et le fluide de refroidissement. Cet isolant 10 peut consister en une feuille (plus connue sous terme anglais « backsheet ») pré-collée aux éléments photovoltaïques 1, ou un colle isolante électrique (par exemple du type gel silicone). Au sens de présente invention, la « face arrière » des éléments photovoltaïques s'entend comme étant isolée électriquement par l'isolant électrique étanche 10 et/ou par la plaque supérieure 13 décrite plus après. La face arrière des éléments photovoltaïques 1 est donc isolée électriquement.

En pratique, l'échangeur E comprend trois zones principales : une zone d'arrivée ZA du fluide de refroidissement, une zone d'échange thermique ZE et une zone d'évacuation ZV dudit fluide. Les éléments photovoltaïques 1 sont préférentiellement regroupés au-dessus de la zone d'échange ZE mais peuvent être répartis au-dessus des zones d'arrivée ZA et d'évacuation ZV. La zone d'échange ZE a par exemple une surface comprise entre 0,5 m² et 4 m².

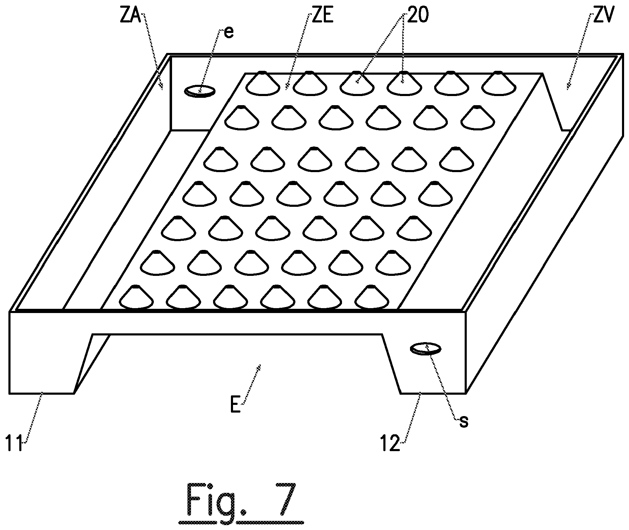

Comme représenté sur la figure 7, l'échangeur E est préférentiellement une pièce monobloc, obtenue par moulage. La configuration de cette pièce monobloc délimite non seulement la zone d'échange ZE mais également les zones d'arrivée ZA et d'évacuation ZV.

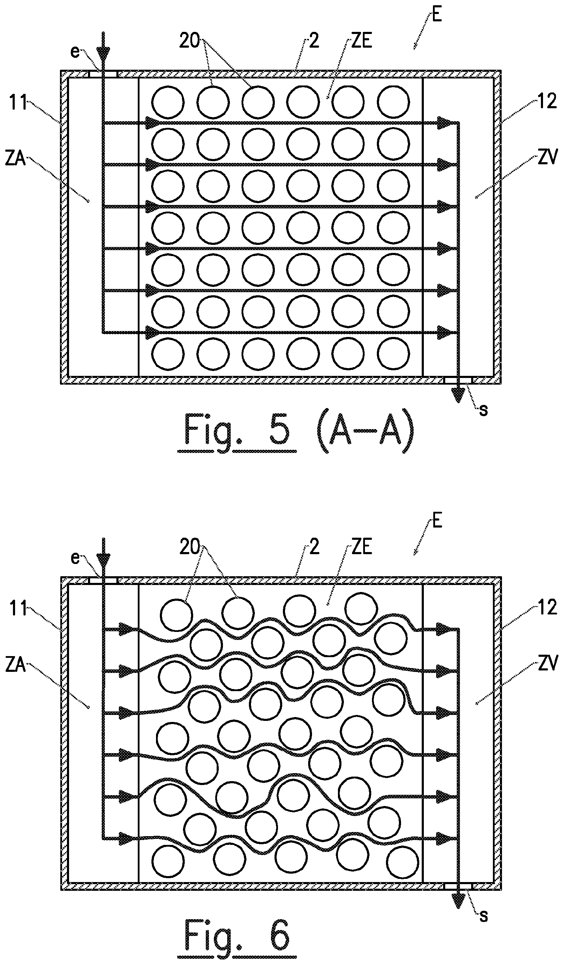

En se rapportant aux figures 1 à 9, les zones d'arrivée ZA et d'évacuation ZV sont formées par des canaux de circulation 11, 12 disposés de part et d'autre de la zone d'échange ZE. Ces canaux 11, 12 ont la forme de gouttières communiquant, par leur bords longitudinaux, avec la zone d'échange ZE. Ils sont parallèles entre eux et sont orientés perpendiculairement au sens d'écoulement du fluide dans la zone d'échange ZE. Sur les figures 5 à 6, l'entrée e et la sortie s du fluide dans l'échangeur E sont prioritairement diagonalement opposées mais peuvent être disposées symétriquement, au même niveau. L'entrée e et la sortie s peuvent être situées dans le fond des canaux de circulation 11, 12 ou être réalisées sur les parois latérales de ces derniers. Les canaux 11, 12, peuvent avoir une section rectangulaire, carrée, trapézoïdale, ronde ou autre, et ont des pertes de charge négligeables par rapport aux pertes de charges de la zone d'échange ZE. En pratique, la profondeur des canaux de circulation 11, 12 est supérieure à l'épaisseur de lame du fluide s'écoulant dans la zone d'échange ZE. Cette quasi-absence de pertes de charge sur les côtés de l'échangeur E joue un rôle de distributeur. En effet, le fluide remplit d'abord intégralement le canal d'arrivée 11 avant de se répandre de manière homogène dans la zone d'échange ZE. Le fluide sort de cette dernière et s'écoule dans le canal de sortie 12, sans trouver d'obstacle. On évite ainsi l'apparition de chemins privilégiés pour le fluide de refroidissement, et on élimine les points chauds sous les éléments photovoltaïques 1.

La zone d'échange thermique ZE est formée par une plaque d'échange inférieure 2 disposée sous les éléments photovoltaïques 1 et sur laquelle s'écoule le fluide de refroidissement. Conformément à l'invention, la plaque inférieure 2 est conformée de façon à former des éléments de perturbation 20. La plaque 2 intègre donc, dès sa fabrication, ces éléments de perturbation 20 qui sont réalisés dans le même matériau que ladite plaque. Ces derniers ont une double fonction :
- perturber l'écoulement du fluide de refroidissement de façon à favoriser les échanges thermique dans la zone d'échange ZE,
- augmenter la surface d'échange thermique et donc participer à l'échange thermique.

En pratique, les éléments de perturbation 20 peuvent avoir la forme de nervures, de mamelons, de demi-sphère, de tubes cylindriques ou polygonaux, de pyramides, etc. Selon la surface de la zone d'échange ZE, le nombre d'éléments de perturbation 20 peut varier de quelque dizaine à plusieurs centaines. On peut par exemple prévoir une ou plusieurs centaines d'éléments de perturbation 20 par m² de surface d'échange. On peut par exemple prévoir 300 éléments de perturbation par m². Ils peuvent être répartis de manière régulière, et plus précisément de manière linéaire, formant des chemins d'écoulement parallèles, comme représentés sur la figure 5. Dans ce cas, l'écoulement du fluide de refroidissement est globalement parallèle, mais localement perturbé au niveau des éléments 20. Dans une variante de réalisation représentée sur la figure 6, les éléments de perturbation 20 peuvent être répartis de manière irrégulières, et notamment en quinconce. Dans ce cas, l'écoulement du fluide de refroidissement est perturbé sans être forcément parallèle.

Les éléments de perturbation 20 s'étendent sur toute l'épaisseur de la lame de fluide s'écoulant dans la zone d'échange ZE. En se rapportant plus particulièrement aux figures 2 et 4, la hauteur « h » des éléments de perturbation 20 correspond à l'épaisseur de la lame de fluide s'écoulant dans la zone d'échange ZE. Il n'y a donc pas de lame de fluide qui puisse passer au-dessus des éléments de perturbation 20. En pratique, l'épaisseur de la lame de fluide dans la zone d'échange ZE (et la hauteur « h » des éléments de perturbation 20) est de quelques millimètres.

On privilégie une plaque 2 en; thermoplastiques tels que polyacéthylène, polyaniline, polypyrrole ou en polymères chargés de poudres ou paillettes métalliques , conducteurs de chaleur et convenant à l'homme du métier. En se rapportant aux figures 1 à 4, il apparait clairement que les éléments de perturbation 20 forment des bosses au niveau de la face supérieure de la plaque 2 sur laquelle s'écoule le fluide de refroidissement et forment des creux au niveau de la face inférieure de ladite plaque qui n'est pas en contact avec ledit fluide et qui est opposée à ladite face supérieure. Ces creux augmentent la surface d'échange thermique entre la plaque 2 et l'air circulant sous la zone d'échange ZE.

En se rapportant au mode de réalisation des figures 1 et 2, l'extrémité supérieure des éléments de perturbation 20 est directement en contact avec la face arrière des éléments photovoltaïques 1. L'extrémité supérieure des éléments de perturbation 20 est par exemple collée à l'isolant 10. Les éléments photovoltaïques 1 sont donc principalement refroidis au niveau de ces points de contact. L'extrémité supérieure des éléments de perturbation 20 est conformée de manière à assurer un contact surfacique avec la face arrière des éléments photovoltaïques 1. Cette surface de contact est avantageusement comprise entre 1 mm² et 10 cm², préférentiellement environ 3 mm², préférentiellement encore environ 4,5 mm². Ce contact surfacique entre l'extrémité supérieure des éléments de perturbation et la face arrière des éléments photovoltaïques 1, assure une transmission efficace de la chaleur vers la plaque inférieure 2. Le fluide de refroidissement récupère donc la chaleur non seulement au niveau de la face arrière des éléments photovoltaïques 1, mais également au niveau de la plaque inférieure 2, ce qui augmente considérablement les échanges thermiques et optimise le refroidissement desdits éléments photovoltaïques.

Dans une variante de réalisation représentée sur les figures 3 et 4, une plaque d'échange supérieure 13 est fixée sur la face arrière des éléments photovoltaïques 1. Comme pour la plaque inférieure 2, on privilégie une plaque supérieure 13 en aluminium, ou en alliages d'aluminium. D'autres matériaux conducteurs de chaleur du type décrits précédemment et convenant à l'homme du métier peuvent toutefois être employés.

L'extrémité supérieure des éléments de perturbation 20 est conformée de manière à assurer un contact surfacique avec cette plaque supérieure 13. Cette surface de contact est avantageusement comprise entre 1 mm² et 10 cm², préférentiellement environ 3 mm², préférentiellement encore environ 4,5 mm². La plaque supérieure 13 est par exemple collée ou soudée aux extrémités des éléments de perturbation 20 et/ou sur les bordures de l'échangeur E.

Plusieurs solutions permettent d'assembler la plaque supérieure 13 et les éléments photovoltaïques 1. La plaque 13 peut par exemple être collée sous une feuille isolante pré-collée sur la face arrière des éléments photovoltaïques 1. On peut également fixer la plaque 13 sur la face arrière des éléments photovoltaïques 1 en utilisant une colle isolante électrique (par ex : gel silicone). Il est encore possible de revêtir d'un film isolant la plaque 13 et de faire le vide entre ladite plaque et une plaque de verre/plastique rigidifiant, les éléments photovoltaïques étant disposés entre les deux dites plaques. La plaque 13 se retrouve plaquée à la plaque de verre/plastique par l'aspiration du vide, les éléments photovoltaïques étant pris en sandwich. En tout état de cause, quelle que soit la technique de fixation employée, la plaque 13 assure une fonction d'étanchéité au fluide de refroidissement.

La plaque inférieure 2 a tendance à être plus froide que la plaque supérieure 13, car les éléments de perturbation 20 permettent de bien la refroidir. L'extrémité supérieure des éléments de perturbations 20 assure un bon contact thermique avec la plaque supérieure 13. Ce contact surfacique entre l'extrémité supérieure des éléments de perturbation 20 et la plaque supérieure 13, assure une transmission efficace de la chaleur vers la plaque inférieure 2. Le fluide de refroidissement récupère donc la chaleur non seulement au niveau de la plaque supérieure 13, mais également au niveau de la plaque inférieure 2, ce qui augmente considérablement les échanges thermiques et optimise le refroidissement desdits éléments photovoltaïques. Du fait de sa bonne conductivité thermique, la température de la plaque supérieure 13 s'homogénéise rapidement, ladite plaque se refroidissant entièrement, sans garder de points froids ou chauds (alors que dans l'exemple des figures 1 et 2, le refroidissement intervenait localement au niveau des extrémités supérieures des éléments de perturbation 20). L'intérêt principal d'obtenir une température homogène sur la plaque supérieure 13, est que les éléments photovoltaïques 1 vont être refroidis de manière homogène, donc sans point chaud. L'efficacité du panneau est donc augmentée, étant rappelé que les éléments photovoltaïques 1 fixent leur production électrique sur l'élément le plus faible, c'est-à-dire le plus chaud.

Conformément à l'invention, la plaque 2 est conformée de façon à ce qu'elle intègre directement les éléments de perturbation 20. La plaque 2 peut également être conformée de façon à constituer tout ou partie du support sur lesquelles reposent les éléments photovoltaïques 1. Son encombrement et son poids étant ainsi réduit, l'échangeur E n'en reste pas moins d'avantage structurant pour le panneau que les échangeurs connus de l'art antérieur. La plaque 2 peut être également être conformée pour former les canaux de distribution 11, 12 (figure 7). Dans ce cas, l'échangeur E est monobloc, formé d'une seule pièce définissant la zone d'arrivée ZA du fluide de refroidissement, la zone d'échange thermique ZE avec éléments de perturbation intégrés et la zone d'évacuation ZV dudit fluide. On peut toutefois prévoir de fixer d'autres pièces à la plaque 2 pour la renforcer. Mais dans tous les cas, le nombre de pièces constitutives de l'échangeur E est réduit par rapport aux échangeurs connus de l'art antérieur.

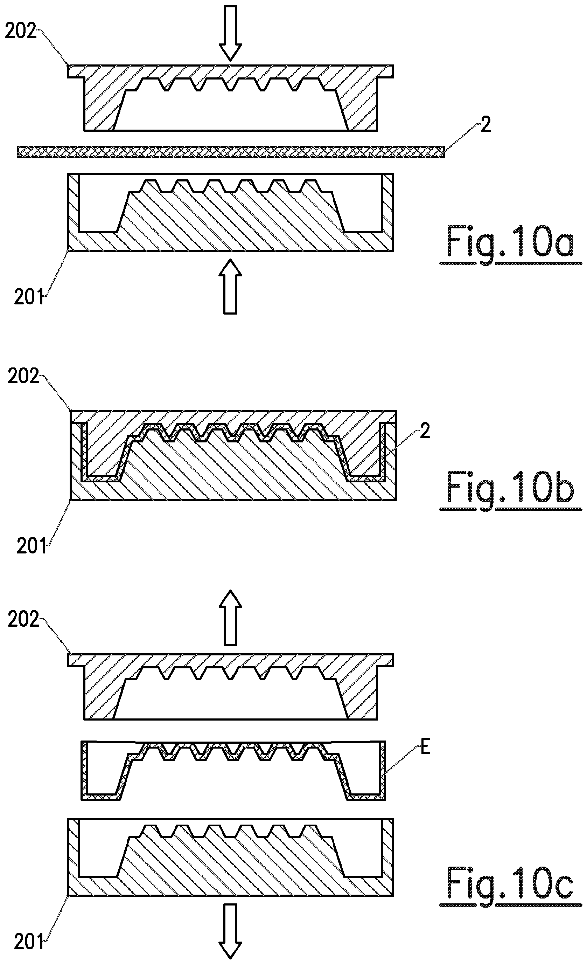

Les figures 10a à 10c schématisent les différentes étapes de fabrication d'un échangeur monobloc intégrant non seulement les éléments de perturbation mais également les canaux latéraux de circulation. La technique illustrée est l'emboutissage (ou le matriçage). Une plaque 2 métallique est disposée au regard d'une matrice 201 et d'un poinçon 202 (figure 10a). La matrice 201 et le poinçon 202 présentent des empreintes complémentaires dont la géométrie correspond à la pièce à réaliser. En pénétrant dans la matrice 201, le poinçon 202 va déformer la plaque 2 pour la conformer à la géométrie voulue (figure 10b). Il suffit alors de séparer le poinçon 202 de la matrice 201 de façon à obtenir l'échangeur E. Le procédé de fabrication étant très simple et très rapide, ce type d'échangeur peut être facilement industrialisé.

Conformément à l'invention, il est également possible d'obtenir un échangeur monobloc avec d'autres techniques de fabrication telles que le moulage, dans le cas où le matériau utilisé est du type thermoplastiques ou polymères chargés.

Les panneaux solaires photovoltaïques utilisent généralement des boîtes de jonction pour loger les diodes by-pass. Ces boîtes ont généralement une forme rectangulaire et sont fixés sur la face arrière du panneau. Compte tenu de l'encombrement de ces boîtes, les panneaux hybrides doivent contourner, par leur géométrie, lesdites boîtes en prévoyant un logement dans l'échangeur. Au niveau de ce logement pour boîte de jonction, l'échange de chaleur est perturbé, voire diminuer, de sorte que les éléments photovoltaïques situés juste au dessus ne sont pas refroidies de manière optimale. Cela affecte le rendement du panneau étant donné que c'est toujours sur l'élément photovoltaïque le plus chaud, donc la plus faible, que s'aligne l'ensemble du panneau.

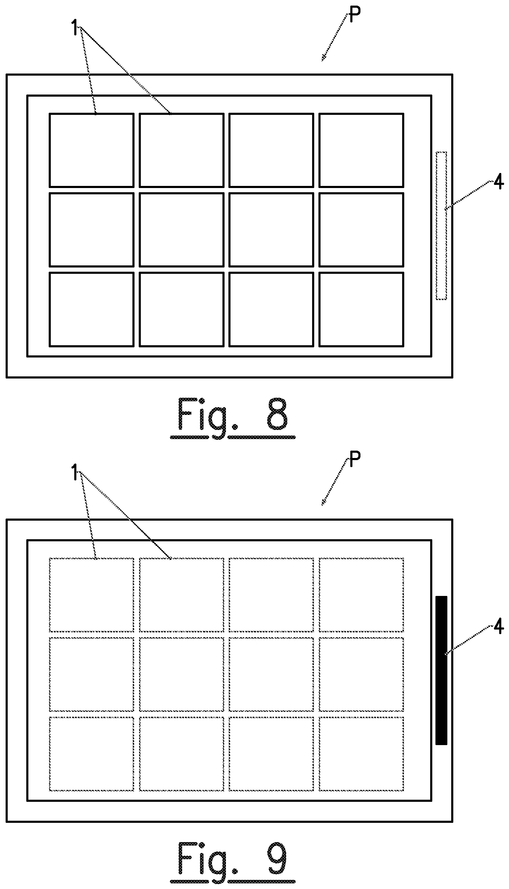

Pour résoudre ce problème, on utilise des boîtiers de jonction fins et longs, par exemple du type boîtiers décentralisés TYCO® ou boîtiers EDGE. En pratique, le boîtier utilisé a une longueur d'environ 130 mm, une largeur d'environ 12 mm et une hauteur d'environ 12 mm. En se rapportant aux figures 8 et 9, ce boitier de jonction 4 est disposé sur la face arrière du panneau P, préférentiellement contre une bordure arrière dudit panneau, et de manière plus générale sans être en vis-à-vis de la face arrière d'un élément photovoltaïque 1. La finesse d'un tel boîtier permet d'être entièrement « au-dessus » de la première rangée d'éléments photovoltaïques 1, ces derniers étant donc tous refroidis de manière homogène.

## Revendications

1. Procédé de fabrication d'un panneau solaire hybride capable de produire une énergie électrique et une énergie thermique, ledit procédé consistant à:
- intégrer, dans le panneau solaire, des éléments photovoltaïques (1) comportant une face avant et une face arrière,
- disposer un échangeur thermique monobloc (E) sous les éléments photovoltaïques (1), la face arrière desdits éléments photovoltaïques étant en vis-à-vis dudit échangeur, lequel échangeur comprend une zone d'échange thermique (ZE),
- former la zone d'échange thermique (ZE) par une plaque inférieure (2) comprenant une face supérieure sur laquelle est destinée à s'écouler un fluide de refroidissement et une face inférieure qui n'est pas en contact avec ledit fluide et qui est opposée à ladite face supérieure,
- intégrer dans la plaque inférieure (2) des éléments (20) adaptés pour perturber l'écoulement du fluide de refroidissement,
**se caractérisant par le fait que** ledit procédé comprend en outre des étapes consistant à :
- conformer la plaque inférieure (2) de sorte qu'elle intègre, dès sa fabrication, les éléments de perturbation (20),
∘ la plaque inférieure (2) est moulée dans un matériau thermoplastique ou un polymère chargé de poudres ou paillettes métalliques, laquelle plaque inférieure forme une plaque d'échange thermique, les éléments de perturbation (20) étant réalisés dans le même matériau que ladite plaque,
∘ les éléments de perturbation (20) forment des bosses au niveau de la face supérieure de la plaque inférieure (2) et forment des creux au niveau de la face inférieure de ladite plaque,
- conformer l'extrémité supérieure des éléments de perturbation (20) de manière à assurer un contact surfacique entre ladite extrémité supérieure et la face arrière des éléments photovoltaïques (1).

2. Procédé selon la revendication 1, dans lequel la surface de contact entre l'extrémité supérieure des éléments de perturbation (20) et la face arrière des éléments photovoltaïques (1) est comprise entre 1 mm² et 10 cm².

3. Procédé de fabrication d'un panneau solaire hybride capable de produire une énergie électrique et une énergie thermique, ledit procédé consistant à :
- intégrer, dans le panneau solaire, des éléments photovoltaïques (1) comportant une face avant et une face arrière,
- disposer un échangeur thermique monobloc (E) sous les éléments photovoltaïques (1), la face arrière desdits éléments photovoltaïques étant en vis-à-vis dudit échangeur, lequel échangeur comprend une zone d'échange thermique (ZE),
- former la zone d'échange thermique (ZE) par une plaque inférieure (2) comprenant une face supérieure sur laquelle est destinée à s'écouler un fluide de refroidissement et une face inférieure qui n'est pas en contact avec ledit fluide et qui est opposée à ladite face supérieure,
- intégrer dans la plaque inférieure (2) des éléments (20) adaptés pour perturber l'écoulement du fluide de refroidissement,
- fixer une plaque d'échange supérieure (13) sur la face arrière des éléments photovoltaïques (1),
**se caractérisant par le fait que** ledit procédé comprend en outre des étapes consistant à :
- conformer la plaque inférieure (2) de sorte qu'elle intègre, dès sa fabrication, les éléments de perturbation (20),
∘ la plaque inférieure (2) est moulée dans un matériau thermoplastique ou un polymère chargé de poudres ou paillettes métalliques, laquelle plaque inférieure forme une plaque d'échange thermique, les éléments de perturbation (20) étant réalisés dans le même matériau que ladite plaque,
∘ les éléments de perturbation (20) forment des bosses au niveau de la face supérieure de la plaque inférieure (2) et forment des creux au niveau de la face inférieure de ladite plaque,
- conformer l'extrémité supérieure des éléments de perturbation (20) de manière à assurer un contact surfacique entre ladite extrémité supérieure et la plaque d'échange supérieure (13).

4. Procédé selon la revendication 3, consistant à réaliser la plaque d'échange supérieure (13) dans un matériau thermoplastique ou un polymère chargé de poudres ou paillettes métalliques.

5. Procédé selon la revendication 3 ou 4, dans lequel la surface de contact entre l'extrémité supérieure des éléments de perturbation (20) et la plaque d'échange supérieure (13) est comprise entre 1 mm² et 10 cm².

6. Procédé selon l'une des revendications précédentes, consistant à conformer la plaque inférieure (2) de sorte qu'elle intègre, dès sa fabrication, des éléments de perturbation (20) ayant la forme de nervures.

7. Procédé selon l'une des revendications précédentes, consistant à conformer la plaque inférieure (2) de sorte qu'elle intègre, dès sa fabrication, des éléments de perturbation (20) ayant la forme de mamelons.

8. Procédé selon l'une des revendications précédentes, consistant à conformer la plaque inférieure (2) de sorte qu'elle intègre, dès sa fabrication, des éléments de perturbation (20) ayant la forme de demi-sphère.

9. Procédé selon l'une des revendications précédentes, consistant à conformer la plaque inférieure (2) de sorte qu'elle intègre, dès sa fabrication, des éléments de perturbation (20) ayant la forme de tubes cylindriques.

10. Procédé selon l'une des revendications précédentes, consistant à conformer la plaque inférieure (2) de sorte qu'elle intègre, dès sa fabrication, des éléments de perturbation (20) ayant la forme de tubes polygonaux.

11. Procédé selon l'une des revendications précédentes, consistant à conformer la plaque inférieure (2) de sorte qu'elle intègre, dès sa fabrication, des éléments de perturbation (20) ayant la forme de pyramides.

12. Procédé selon l'une des revendications précédentes, consistant à conformer la plaque d'échange (2) de façon à former, dès la fabrication de ladite plaque, une ou plusieurs centaines d'éléments de perturbation (20) par m² de surface d'échange, lesdits éléments étant répartis en quinconce.

13. Procédé selon l'une des revendications précédentes, consistant à conformer la plaque inférieure (2) de façon à constituer non seulement la zone d'échange (ZE) de l'échangeur thermique (E), mais également une zone d'arrivée (ZA) et une zone d'évacuation (ZV) du fluide de refroidissement, l'échangeur thermique (E) étant une pièce monobloc.

14. Procédé selon l'une des revendications précédentes, consistant à conformer la plaque inférieure (2) de façon à constituer non seulement la zone d'échange (ZE), mais également tout ou partie du support sur lesquelles reposent les éléments photovoltaïques (1).

15. Procédé selon l'une des revendications précédentes, consistant à conformer la plaque inférieure (2) de façon à former des canaux de circulation (11, 12) du fluide de refroidissement disposés de part et d'autre de la zone d'échange (ZE), lesdits canaux ayant des pertes de charge assurant une répartition homogène dudit fluide dans ladite zone d'échange.

## Patentansprüche

1. Verfahren zur Herstellung eines hybriden Solarpaneels, das eine elektrische Energie und eine thermische Energie erzeugen kann, wobei das Verfahren darin besteht:
- in das Solarpaneel Photovoltaikelemente (1) zu integrieren, die eine Vorderseite und eine Rückseite aufweisen,
- einen einstückigen Wärmetauscher (E) unter den Photovoltaikelementen (1) anzuordnen, wobei die Rückseite der Photovoltaikelemente dem Tauscher gegenüberliegt, wobei der Tauscher eine Wärmeaustauschzone (ZE) enthält,
- die Wärmeaustauschzone (ZE) durch eine untere Platte (2) zu bilden, die eine Oberseite, auf der ein Kühlfluid fließen soll, und eine Unterseite enthält, die nicht mit dem Fluid in Kontakt ist und die der Oberseite entgegengesetzt liegt,
- in die untere Platte (2) Elemente (20) zu integrieren, die geeignet sind, das Fließen des Kühlfluids zu stören,
**dadurch gekennzeichnet, dass** das Verfahren außerdem Schritte enthält, die darin bestehen:
- die untere Platte (2) derart zu gestalten, dass sie ab ihrer Herstellung die Störelemente (20) umfasst,
∘ die untere Platte (2) wird aus einem thermoplastischen Material oder einem mit Metallpulvern oder -flittern angereicherten Polymer geformt, wobei die untere Platte eine Wärmeaustauschplatte bildet, wobei die Störelemente (20) aus dem gleichen Material wie die Platte hergestellt werden,
∘ die Störelemente (20) bilden Buckel im Bereich der Oberseite der unteren Platte (2) und bilden Vertiefungen im Bereich der Unterseite der Platte,
- das obere Ende der Störelemente (20) derart zu gestalten, dass ein Oberflächenkontakt zwischen dem oberen Ende und der Rückseite der Photovoltaikelemente (1) gewährleistet wird.

2. Verfahren nach Anspruch 1, wobei die Kontaktfläche zwischen dem oberen Ende der Störelemente (20) und der Rückseite der Photovoltaikelemente (1) zwischen 1 mm² und 10 cm² liegt.

3. Verfahren zur Herstellung eines hybriden Solarpaneels, das eine elektrische Energie und eine thermische Energie erzeugen kann, wobei das Verfahren darin besteht:
- in das Solarpaneel Photovoltaikelemente (1) zu integrieren, die eine Vorderseite und eine Rückseite aufweisen,
- einen einstückigen Wärmetauscher (E) unter den Photovoltaikelementen (1) anzuordnen, wobei die Rückseite der Photovoltaikelemente dem Tauscher gegenüberliegt, wobei der Tauscher eine Wärmeaustauschzone (ZE) enthält,
- die Wärmeaustauschzone (ZE) durch eine untere Platte (2) zu bilden, die eine Oberseite, auf der ein Kühlfluid fließen soll, und eine Unterseite enthält, die nicht mit dem Fluid in Kontakt ist und die der Oberseite entgegengesetzt liegt,
- in die untere Platte (2) Elemente (20) zu integrieren, die geeignet sind, das Fließen des Kühlfluids zu stören,
- eine obere Austauschplatte (13) an der Rückseite der Photovoltaikelemente (1) zu befestigen,
**dadurch gekennzeichnet, dass** das Verfahren außerdem Schritte enthält, die darin bestehen:
- die untere Platte (2) derart zu gestalten, dass sie ab ihrer Herstellung die Störelemente (20) umfasst,
∘ die untere Platte (2) wird aus einem thermoplastischen Material oder einem mit Metallpulvern oder -flittern angereicherten Polymer geformt, wobei die untere Platte eine Wärmeaustauschplatte bildet, wobei die Störelemente (20) aus dem gleichen Material wie die Platte hergestellt werden,
∘ die Störelemente (20) bilden Buckel im Bereich der Oberseite der unteren Platte (2) und bilden Vertiefungen im Bereich der Unterseite der Platte,
- das obere Ende der Störelemente (20) derart zu gestalten, dass ein Oberflächenkontakt zwischen dem oberen Ende und der oberen Austauschplatte (13) gewährleistet wird.

4. Verfahren nach Anspruch 3, das darin besteht, die obere Austauschplatte (13) aus einem thermoplastischen Material oder einem mit Metallpulvern oder -flittern angereicherten Polymer herzustellen.

5. Verfahren nach Anspruch 3 oder 4, wobei die Kontaktfläche zwischen dem oberen Ende der Störelemente (20) und der oberen Austauschplatte (13) zwischen 1 mm² und 10 cm² liegt.

6. Verfahren nach einem der vorhergehenden Ansprüche, das darin besteht, die untere Platte (2) so zu gestalten, dass sie ab ihrer Herstellung Störelemente (20) umfasst, die die Form von Rippen haben.

7. Verfahren nach einem der vorhergehenden Ansprüche, das darin besteht, die untere Platte (2) so zu gestalten, dass sie ab ihrer Herstellung Störelemente (20) umfasst, die die Form von Nippeln haben.

8. Verfahren nach einem der vorhergehenden Ansprüche, das darin besteht, die untere Platte (2) so zu gestalten, dass sie ab ihrer Herstellung Störelemente (20) umfasst, die die Form einer Halbkugel haben.

9. Verfahren nach einem der vorhergehenden Ansprüche, das darin besteht, die untere Platte (2) so zu gestalten, dass sie ab ihrer Herstellung Störelemente (20) umfasst, die die Form zylindrischer Rohre haben.

10. Verfahren nach einem der vorhergehenden Ansprüche, das darin besteht, die untere Platte (2) so zu gestalten, dass sie ab ihrer Herstellung Störelemente (20) umfasst, die die Form polygonaler Rohre haben.

11. Verfahren nach einem der vorhergehenden Ansprüche, das darin besteht, die untere Platte (2) so zu gestalten, dass sie ab ihrer Herstellung Störelemente (20) umfasst, die die Form von Pyramiden haben.

12. Verfahren nach einem der vorhergehenden Ansprüche, das darin besteht, die Austauschplatte (2) so zu gestalten, dass ab der Herstellung der Platte einhundert oder mehrere hundert Störelemente (20) pro m² Austauschfläche gebildet werden, wobei die Elemente auf Lücke verteilt sind.

13. Verfahren nach einem der vorhergehenden Ansprüche, das darin besteht, die untere Platte (2) so zu gestalten, dass sie nicht nur die Austauschzone (ZE) des Wärmetauschers (E), sondern ebenfalls eine Zufuhrzone (ZA) und eine Abfuhrzone (ZV) des Kühlfluids bildet, wobei der Wärmetauscher (E) ein einstückiges Bauteil ist.

14. Verfahren nach einem der vorhergehenden Ansprüche, das darin besteht, die untere Platte (2) so zu gestalten, dass sie nicht nur die Austauschzone (ZE), sondern auch den ganzen oder einen Teil des Trägers bildet, auf dem die Photovoltaikelemente (1) ruhen.

15. Verfahren nach einem der vorhergehenden Ansprüche, das darin besteht, die untere Platte (2) so zu gestalten, dass Strömungskanäle (11, 12) des Kühlfluids gebildet werden, die zu beiden Seiten der Austauschzone (ZE) angeordnet sind, wobei die Kanäle Druckverluste haben, die eine homogene Verteilung des Fluids in der Austauschzone gewährleisten.

## Claims

1. Process for manufacturing a hybrid solar panel capable of generating electrical energy and thermal energy, said process consisting in:
- integrating, into the solar panel, photovoltaic elements (1) having a front face and a back face;
- placing a single-piece heat exchanger (E) under the photovoltaic elements (1), the back face of said photovoltaic elements facing said exchanger, which exchanger comprises a heat-exchange zone (ZE);
- forming the heat-exchange zone (ZE) with a lower plate (2) comprising an upper face over which a coolant is intended to flow and a lower face that does not make contact with said coolant and that is opposite said upper face;
- integrating into the lower plate (2) elements (20) suitable for disrupting the flow of the coolant;
**characterized in that** said process furthermore comprises steps consisting in:
- shaping the lower plate (2) so that it has incorporated, from its manufacture, the disrupting elements (20),
∘ the lower plate (2) is moulded in a thermoplastic or a polymer filled with metal flakes or powders, which lower plate forms a heat-exchange plate, the disrupting elements (20) being made from the same material as said plate;
∘ the disrupting elements (20) form protrusions in the upper face of the lower plate (2) and form recesses in the lower face of said plate; and
- shaping the upper end of the disrupting elements (20) so as to ensure an areal contact between said upper end and the back face of the photovoltaic elements (1).

2. Process according to Claim 1, wherein the area of contact between the upper end of the disrupting elements (20) and the back face of the photovoltaic elements (1) is comprised between 1 mm² and 10 cm².

3. Process for manufacturing a hybrid solar panel capable of generating electrical energy and thermal energy, said process consisting in:
- integrating, into the solar panel, photovoltaic elements (1) having a front face and a back face;
- placing a single-piece heat exchanger (E) under the photovoltaic elements (1), the back face of said photovoltaic elements facing said exchanger, which exchanger comprises a heat-exchange zone (ZE);
- forming the heat-exchange zone (ZE) with a lower plate (2) comprising an upper face over which a coolant is intended to flow and a lower face that does not make contact with said coolant and that is opposite said upper face;
- integrating into the lower plate (2) elements (20) suitable for disrupting the flow of the coolant;
- fastening an upper exchange plate (13) to the back face of the photovoltaic elements (1);
**characterized in that** said process furthermore comprises steps consisting in:
- shaping the lower plate (2) so that it has incorporated, from its manufacture, the disrupting elements (20),
∘ the lower plate (2) is moulded in a thermoplastic or a polymer filled with metal flakes or powders, which lower plate forms a heat-exchange plate, the disrupting elements (20) being made from the same material as said plate;
∘ the disrupting elements (20) form protrusions in the upper face of the lower plate (2) and form recesses in the lower face of said plate; and
- shaping the upper end of the disrupting elements (20) so as to ensure an areal contact between said upper end and the upper exchange plate (13).

4. Process according to Claim 3, consisting in producing the upper exchange plate (13) from a thermoplastic or a polymer filled with metal flakes or powders.

5. Process according to Claim 3 or 4, wherein the area of contact between the upper end of the disrupting elements (20) and the upper exchange plate (13) is comprised between 1 mm² and 10 cm².

6. Process according to one of the preceding claims, consisting in shaping the lower plate (2) so that it has incorporated, from its manufacture, disrupting elements (20) taking the form of ribs.

7. Process according to one of the preceding claims, consisting in shaping the lower plate (2) so that it has incorporated, from its manufacture, disrupting elements (20) taking the form of hummocks.

8. Process according to one of the preceding claims, consisting in shaping the lower plate (2) so that it has incorporated, from its manufacture, disrupting elements (20) of hemispherical shape.

9. Process according to one of the preceding claims, consisting in shaping the lower plate (2) so that it has incorporated, from its manufacture, disrupting elements (20) taking the form cylindrical tubes.

10. Process according to one of the preceding claims, consisting in shaping the lower plate (2) so that it has incorporated, from its manufacture, disrupting elements (20) taking the form of polygonal tubes.

11. Process according to one of the preceding claims, consisting in shaping the lower plate (2) so that it has incorporated, from its manufacture, disrupting elements (20) taking the form of pyramids.

12. Process according to one of the preceding claims, consisting in shaping the exchange plate (2) so as to form, from the manufacture of said plate, one or more hundred disrupting elements (20) per m² of exchange area, said elements being arranged in staggered rows.

13. Process according to one of the preceding claims, consisting in shaping the lower plate (2) so as to form not only the exchange zone (ZE) of the heat exchanger (E), but also an inlet zone (ZE) and an outlet zone (ZV) for the coolant, the heat exchanger (E) being a single-piece part.

14. Process according to one of the preceding claims, consisting in shaping the lower plate (2) so as to form not only the exchange zone (ZE), but also all or some of the carrier on which the photovoltaic elements (1) rest.

15. Process according to one of the preceding claims, consisting in shaping the lower plate (2) so as to form flow channels (11, 12) for the coolant, said channels being placed on either side of the exchange zone (ZE) and having head losses ensuring a uniform distribution of said coolant in said exchange zone.
